# FASCICULE DE BREVET EUROPEEN

(11) **EP 1 738 444 B1**
(45) Date de publication et mention de la délivrance du brevet: **29.04.2009**
(21) Numéro de dépôt: 05717003.7
(22) Date de dépôt: 11.03.2005
(51) Int. Cl.: H01S 5/062, G01S 17/32, G01S 17/58, G01S 7/491

(54) **DISPOSITIF DE DECALAGE DE FREQUENCE DANS UN CHEMIN OPTIQUE A SOURCE LASER PULSEE**
EINRICHTUNG ZUR FREQUENZVERSCHIEBUNG IN EINEM OPTISCHEN FELD MIT EINER GEPULSTEN LASERQUELLE
DEVICE FOR SHIFTING FREQUENCY IN AN OPTICAL FIELD WITH A PULSED LASER SOURCE

(30) Priorité: 12.03.2004 FR 0402599
(43) Date de publication de la demande: 03.01.2007
(73) Titulaire: THALES, 92200 Neuilly sur Seine (FR)
(72) Inventeur: BAILLON, Bertrand, F-94117 ARCUEIL Cedex (FR); SCHLOTTERBECK, Jean-Pierre, F-94117 ARCUEIL Cedex (FR); RENARD, Alain, F-94117 ARCUEIL Cedex (FR)
(74) Mandataire: Chaverneff, Vladimir
(86) Numéro de dépôt international: PCT/EP2005/051107
(87) Numéro de publication internationale: WO 2005/099052

(56) Documents cités:
- EP-A- 0 601 847
- FR-A- 2 757 640
- US-A- 6 141 086
- US-A1- 2002 075 475
- US-A1- 2003 198 271

## Description

La présente invention se rapporte à un procédé de décalage de fréquence dans un chemin optique à source laser à émission pulsée.

Dans des dispositifs comportant une source laser et une détection cohérente hétérodyne, il peut être nécessaire de déterminer une variation de fréquence (effet Doppler) se produisant sur une partie du trajet du faisceau laser et résultant d'un phénomène physique que l'on désire compenser ou mesurer. Ceci est en particulier le cas des Lidars servant à mesurer la vitesse et la direction du vent par rétrodiffusion du faisceau laser sur des aérosols portés par le vent. Cette variation de fréquence est généralement déterminée par mélange du signal reçu avec un signal généré par un oscillateur local et affecté d'un décalage de fréquence qui est produit par un modulateur de type électro-optique ou acousto-optique. (voir par exemple FR-A-2757640)

Un tel dispositif modulateur est cher, volumineux, peu discret, car il rayonne en haute fréquence (présence de raies harmoniques de la fréquence fondamentale du signal, susceptibles de perturber le traitement de signal effectué en aval, ce qui risque de limiter la précision de la mesure de vitesse et de rétrécir la fenêtre de mesure spectrale).

La présente invention a pour objet un procédé de décalage de fréquence dans un chemin optique tel que décrit dans la Revendication 1.

Le support de propagation optique (voir la Revendication 1) peut être soit une fibre optique, soit un guide d'ondes optique, soit un cristal électro-optique.

Dans le cas où le système dans lequel on fait varier la fréquence est un Lidar, l'évolution de la longueur du chemin optique du support de propagation optique est avantageusement linéaire, et elle est réalisée par évolution, avantageusement linéaire, au cours des impulsions considérées, de la contrainte appliquée à la fibre optique ou au guide d'ondes ou de la tension appliquée au cristal électro-optique.

La présente invention sera mieux comprise à la lecture de la description détaillée d'un mode de réalisation, pris à titre d'exemple non limitatif et illustré par le dessin annexé, sur lequel :
- la figure 1 est un bloc-diagramme simplifié d'un Lidar de l'art antérieur, du type cité en préambule,
- la figure 2 est un bloc-diagramme simplifié d'un Lidar comportant un circuit de décalage de fréquence conforme à l'invention, et
- la figure 3 est un bloc-diagramme simplifié d'un exemple d'un ensemble de deux modules de décalage de fréquence conforme à l'invention.

La présente invention est décrite ci-dessous en référence à un Lidar, mais il est bien entendu qu'elle n'est pas limitée à cette seule application, et qu'elle peut être mise en oeuvre dans divers domaines dans lesquels on a besoin de produire un décalage en fréquence sur des fréquences élevées telles que les fréquences supérieures à quelques Ghz.

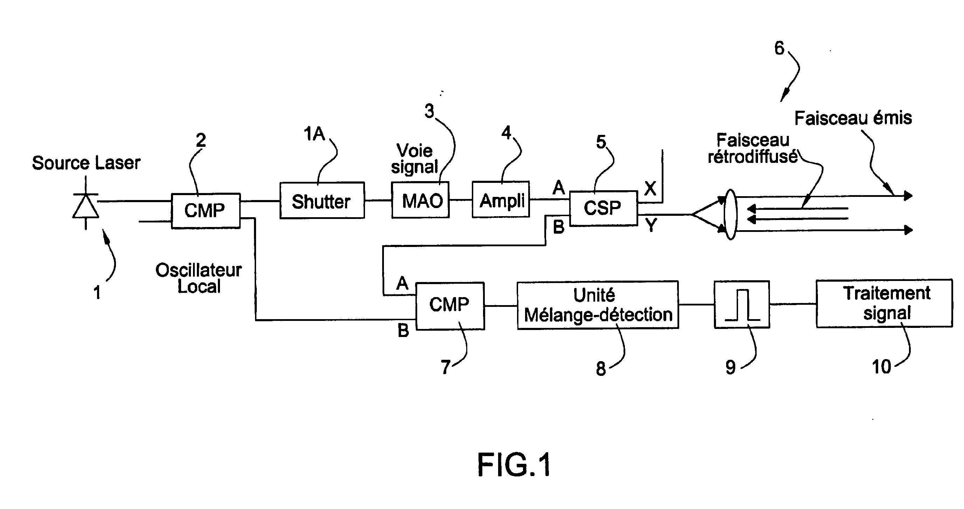

On a représenté sur le bloc-diagramme de la figure 1 une source laser 1 reliée à une entrée d'un coupleur 2 à maintien de polarisation. Une première sortie du coupleur 2, correspondant à la voie « signal », est reliée, par l'intermédiaire d'un élément 1A de découpage impulsionnel (connu également sous l'appellation de « shutter », et qui peut être de type électro-optique) à un modulateur acousto-optique 3, suivi d'un amplificateur 4. L'amplificateur 4 est relié à une première borne d'un coupleur 5 à séparation de polarisations. Une sortie du coupleur 5 est reliée à un système d'émission-réception de faisceaux Lidar, référencé 6 dans son ensemble. La deuxième sortie du coupleur 2 est reliée à une première entrée d'un coupleur à maintien de polarisation 7, dont l'autre entrée est reliée au coupleur 5. La sortie du coupleur 7 est reliée à une unité de mélange et de détection 8, suivie d'un circuit de filtrage 9 et de circuits 10 de traitement de signal.

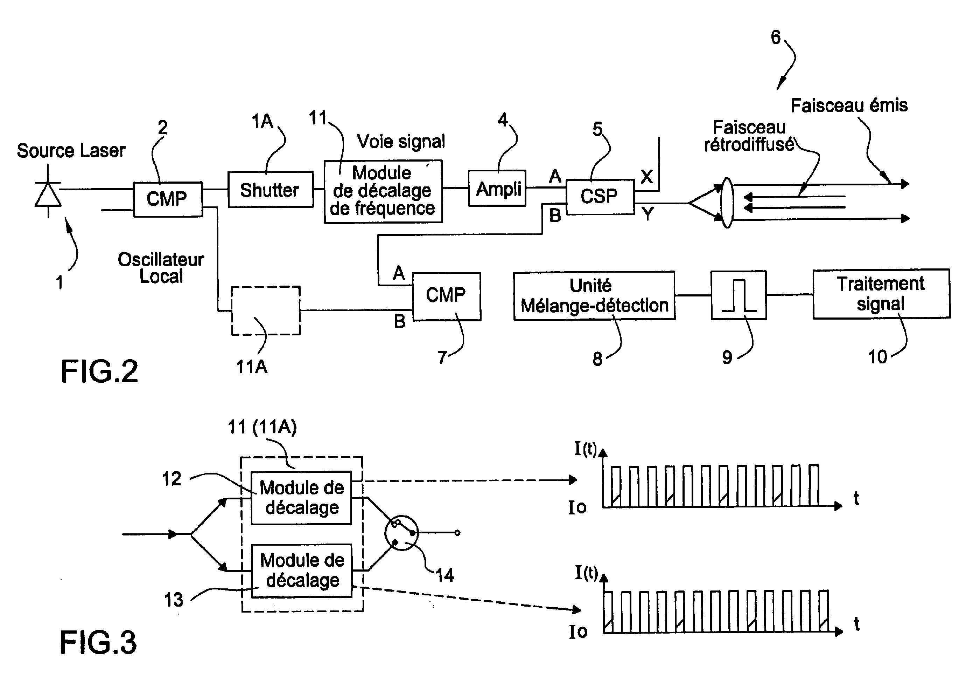

Dans le bloc-diagramme de la figure 2, les éléments similaires à ceux de la figure 1 sont affectés des mêmes références numériques. La différence essentielle entre les systèmes des figures 1 et 2 est que le modulateur 3 de la figure 1 a été remplacé par un dispositif 11 de décalage de fréquence. Les autres éléments du système de la figure 2 peuvent être les mêmes que ceux de la figure 1.

Le dispositif 11 peut comporter un ou plusieurs modules élémentaires de décalage de fréquence. Chacun de ces modules élémentaires comporte un support de propagation optique tel qu'une fibre optique, un guide d'ondes optique ou un cristal électro-optique. On agit sur ce support de façon à en faire varier périodiquement, au cours de chaque n-ième impulsion d'émission de faisceau laser, la longueur de chemin optique en fonction du décalage de fréquence désiré, avec n≥1 . Cette variation de longueur de trajet correspond à une variation d'indice de réfraction du support optique. Dans le cas où ce support est une fibre optique ou un guide d'ondes, cette variation peut être obtenue en imposant une contrainte mécanique au support optique. S'il s'agit d'un cristal électro-optique, la variation est obtenue en appliquant une tension électrique appropriée à ses électrodes. A ce propos, il est important de noter que le cristal électro-optique ne fonctionne alors pas en modulateur électro-optique classique, mais en dispositif provoquant un décalage, fixe ou variable, de la fréquence du faisceau laser pulsé qu'il reçoit.

Dans chaque module, l'évolution de la contrainte mécanique ou de la tension électrique est, dans le cas présent, linéaire en fonction du temps. Cette évolution linéaire engendre un décalage Doppler constant, et par conséquent un décalage fixe de fréquence entre les voies « signal » et « oscillateur local », ce qui permet la détection cohérente hétérodyne. Ce décalage Doppler est imposé à la voie « signal » dans laquelle est inséré le dispositif 11 (comme représenté en traits continus sur la figure 2), et/ou dans la voie « oscillateur local » (le deuxième dispositif à modules de décalage est alors référencé 11A et dessiné en traits interrompus sur la figure 2). Une variation de la longueur du chemin optique est engendrée lorsque la vitesse du faisceau traversant le dispositif 11 (et/ou 11A) varie. Cette vitesse varie de manière inversement proportionnelle à l'indice de réfraction du milieu traversé.

Selon une variante de l'invention, on fait passer deux ou plusieurs fois le faisceau laser dans le dispositif de décalage. La première raison est d'ordre économique : si la pente en tension appliquée n'est pas suffisante pour obtenir le décalage voulu sur la durée de l'impulsion, on fait traverser une nouvelle fois au faisceau le module pour atteindre le décalage final désiré. La deuxième raison est que le module de décalage pourrait très bien être situé derrière le coupleur 5, juste avant l'émission du faisceau dans l'atmosphère, auquel cas le faisceau rétrodiffusé pourrait subir lui-même un décalage (identique ou inverse ou autre que le décalage initial). Le décalage de fréquence généré par le dispositif 11 (et/ou 11A) peut être contrôlé à l'aide de la valeur de la mesure du décalage à la sortie de ce dispositif de décalage. La tension de commande électro-optique ou la contrainte mécanique appliquée au support de propagation optique de ce dispositif (donc la loi d'évolution du décalage de fréquence) peut alors être asservie à une valeur fixe ou évoluant selon une loi déterminée qui est fonction de l'application considérée. Cette mesure de décalage de fréquence peut être utilisée pour déterminer un niveau de bruit ou dans le post-traitement effectué dans les circuits de traitement de signal du signal rétro-diffusé. L'invention est également applicable lorsque l'on effectue des mélanges en BLU (en phase et en quadrature de phase).

Selon un aspect avantageux de l'invention, et comme représenté en figure 3, on munit le dispositif 11 (et/ou 11A) de deux modules de décalage identiques 12, 13, branchés en parallèle, et suivis d'un commutateur 14. Il est bien entendu que le dispositif 11 (et/ou 11A) peut comporter plus de deux modules. Le shutter 1A est commandé de façon à découper régulièrement le faisceau laser continu incident et produire ainsi des impulsions régulièrement espacées. Selon l'invention, dans chaque module de décalage 12, 13, on opère périodiquement un décalage de fréquence pour chaque n-ième impulsion (n≥1), c'est-à-dire que les impulsions successives sont groupées en séries successives de n impulsions chacune, et on traite la première impulsion de chaque série en lui appliquant ladite loi d'évolution, ces séries comportant chacune au moins une impulsion. Les impulsions passant dans le module 13 peuvent être synchrones ou non de celles passant dans le module 12. Dans le cas illustré en figure 3, les impulsions passant dans le module 13 sont décalées dans le temps (à l'aide de moyens connus en soi et non représentés) par rapport à celles passant dans le module 12. La loi d'évolution appliquée aux impulsions dans le module 13 peut être différente ou non de celle appliquée dans le module 12. Le commutateur 14 est commandé de façon à recueillir le faisceau de sortie de l'un ou l'autre module, par exemple en fonction de la nature des cibles visées par un Lidar équipé du dispositif de l'invention.

Selon une variante de l'invention, on utilise un seul module de décalage, le commutateur 14 étant alors supprimé.

Les applications du dispositif de l'invention sont nombreuses : outre l'application considérée ici aux Lidars de télémétrie et de vélocimétrie, avec, le cas échéant des faisceaux « chirpés », on citera les télécommunications (multiplexeurs et démultiplexeurs, par exemple), la réduction des effets Brillouin dans les guides d'ondes optiques, etc.

Le dispositif de l'invention, grâce au remplacement du modulateur acousto-optique ou électro-optique classique par un dispositif de décalage à variation de longueur de parcours optique, permet d'éviter l'émission de raies harmoniques gênantes, et d'éviter la production d'une modulation radiofréquence. Les contraintes mécaniques ou électriques mises en jeu dans ce dispositif de décalage sont faibles et donc faciles à produire. Les technologies électro-optiques employées par l'invention sont issues de celles couramment employées en télécommunications, les composants utilisés étant compacts et peu coûteux, car réalisés en technique intégrée. On peut encore réduire les coûts de ces composants en les hybridant sur un guide d'ondes planaire (en technologie d'optique intégrée), ce qui réduit le nombre de connexions par fils et fibres optiques.

## Revendications

1. Procédé de production d'un décalage de fréquence (11, 11A) dans un chemin optique à source laser à émission pulsée, **caractérisé en ce qu'**on fait varier périodiquement, au cours de chaque n-ième impulsion d'émission de faisceau laser la longueur de chemin optique d'au moins un module de décalage en fréquence (12, 13) contenant un support de propagation optique en fonction du décalage de fréquence désiré, avec n≥1, en appliquant à ce(s) module(s) une tension de commande ou une contrainte mécanique évoluant de façon linéaire en fonction du temps pendant cette n-ième impulsion.

2. Procédé selon la revendication 1, **caractérisé en ce que** le support de propagation optique est l'un des dispositifs suivants : une fibre optique, un guide d'ondes ou un cristal électro-optique.

3. Procédé selon la revendication 1 ou 2, **caractérisé en ce que** le système dans lequel on fait varier la fréquence est un Lidar et que l'évolution de la longueur du chemin optique du support de propagation optique est linéaire.

4. Procédé selon la revendication 3, **caractérisé en ce que** les lois d'évolution sont égales d'une impulsion choisie à la suivante.

5. Procédé selon la revendication 3, **caractérisé en ce que** les lois d'évolution sont différentes d'une impulsion choisie à la suivante.

6. Procédé selon l'une des revendications précédentes, **caractérisé en ce que** l'on branche en parallèle au moins deux modules de décalage de fréquence (12,13), un commutateur (14) étant branché aux sorties de ces modules et commandé pour recueillir le faisceau optique de sortie de l'un ou l'autre module.

7. Procédé selon l'une des revendications précédentes, **caractérisé en ce que** la loi d'évolution du décalage de fréquence est asservie à une valeur fixe.

8. Procédé selon l'une des revendications 1 à 6, **caractérisé en ce que** la loi d'évolution du décalage de fréquence est asservie à une valeur variable.

## Claims

1. Method of producing a frequency shift (11, 11A) in an optical path containing a pulsed laser source, **characterized in that**, during each nth laser beam pulse, a periodic variation is introduced into the optical path length of at least one frequency-shift module (12, 13) containing an optical propagation medium according to the desired frequency shift, where n ≥ 1, by applying, to this (these) module(s), a control voltage or a mechanical stress that varies linearly as a function of time over this nth pulse.

2. Method according to Claim 1, **characterized in that** the optical propagation medium is one of the following devices: an optical fibre, a waveguide, or an electrooptic crystal.

3. Method according to Claim 1 or 2, **characterized in that** the system in which the frequency is varied is a lidar and **in that** the variation in the optical path length of the optical propagation medium is a linear variation.

4. Method according to Claim 3, **characterized in that** the laws of variation are the same from one chosen pulse to the next.

5. Method according to Claim 3, **characterized in that** the laws of variation are different from one chosen pulse to the next.

6. Method according to one of the preceding claims, **characterized in that** at least two frequency-shift modules (12, 13) are connected in parallel, a switch (14) being connected to the outputs of these modules and controlled in order to collect the optical output beam of one or other module.

7. Method according to one of the preceding claims, **characterized in that** the law of variation of the frequency shift is slaved to a fixed value.

8. Method according to one of Claims 1 to 6, **characterized in that** the law of variation of the frequency shift is slaved to a variable value.

## Patentansprüche

1. Verfahren zur Erzeugung einer Frequenzverschiebung (11, 11A) in einem optischen Weg mit einer Laserquelle mit gepulster Emission, **dadurch gekennzeichnet, dass** während jedes n-ten Laserstrahl-Emissionsimpulses die optische Weglänge mindestens eines einen optischen Ausbreitungsträger enthaltenden Frequenzverschiebungsmoduls (12, 13) abhängig von der gewünschten Frequenzverschiebung periodisch verändert wird, mit n≥1, indem an dieses (diese) Modul(e) eine Steuerspannung oder eine mechanische Belastung angelegt wird, die sich während dieses n-ten Impulses linear in Abhängigkeit von der Zeit entwickelt.

2. Verfahren nach Anspruch 1, **dadurch gekennzeichnet, dass** der optische Ausbreitungsträger eine der folgenden Einrichtungen ist: eine Lichtleitfaser, ein Wellenleiter oder ein elektro-optischer Kristall.

3. Verfahren nach Anspruch 1 oder 2, **dadurch gekennzeichnet, dass** das System, in dem die Frequenz verändert wird, ein Lidar ist, und dass die Entwicklung der optischen Weglänge des optischen Ausbreitungsträgers linear ist.

4. Verfahren nach Anspruch 3, **dadurch gekennzeichnet, dass** die Entwicklungsgesetze von einem gewählten Impuls zum nächsten gleich sind.

5. Verfahren nach Anspruch 3, **dadurch gekennzeichnet, dass** die Entwicklungsgesetze von einem gewählten Impuls zum nächsten unterschiedlich sind.

6. Verfahren nach einem der vorhergehenden Ansprüche, **dadurch gekennzeichnet, dass** mindestens zwei Frequenzverschiebungsmodule (12, 13) parallelgeschaltet werden, wobei ein Schalter (14) an die Ausgänge dieser Module angeschlossen ist und gesteuert wird, um den optischen Ausgangsstrahl von dem einen oder dem anderen Modul zu empfangen.

7. Verfahren nach einem der vorhergehenden Ansprüche, **dadurch gekennzeichnet, dass** das Entwicklungsgesetz der Frequenzverschiebung auf einen festen Wert geregelt wird.

8. Verfahren nach einem der Ansprüche 1 bis 6, **dadurch gekennzeichnet, dass** das Entwicklungsgesetz der Frequenzverschiebung auf einen variablen Wert geregelt wird.
